# EUROPÄISCHE PATENTANMELDUNG

(11) **EP 1 796 232 A1**
(43) Veröffentlichungstag der Anmeldung: **13.06.2007**
(21) Anmeldenummer: 06023061.2
(22) Anmeldetag: 06.11.2006
(51) Int. Cl.: H01S 5/183, H01S 5/14

(54) **Vertikal emittierender, optisch gepumpter Halbleiterlaser mit externem Resonator**

(30) Priorität: 09.12.2005 DE 102005058900
(71) Anmelder: Osram Opto Semiconductors GmbH, 93049 Regensburg (DE)
(72) Erfinder: Brick, Peter, 93051 Regensburg (DE); Lutgen, Stephan, 93047 Regensburg (DE)
(74) Vertreter: Epping - Hermann - Fischer

(57) **Zusammenfassung**

Die Erfindung betrifft einen vertikal emittierender Halbleiterlaser mit einem externen Resonator (7), einem Halbleiterkörper (1) und mindestens einer Pumpstrahlungsquelle (9). Der Halbleiterkörper (1) weist eine Quantenschichtstruktur (2) als aktive Zone auf, die Quantenschichten (3) und dazwischen liegende Barriereschichten (4) umfasst. Weiterhin weist der Halbleiterkörper (1) auf einer Seite der Quantenschichtstruktur (2) einen Bragg-Reflektor (5) auf. Erfindungsgemäß umfasst der Bragg-Reflektor (5) Schichten, die aperiodisch derart zueinander angeordnet sind, dass eine Absorption der Pumpstrahlung (10) im wesentlichen innerhalb der Quantenschichtstruktur (2) erfolgt.

## Beschreibung

Die Erfindung betrifft einen vertikal emittierenden Halbleiterlaser mit einem externen Resonator, einem Halbleiterkörper, sowie einen Bragg-Reflektor. In dem Halbleiterkörper befindet sich eine Quantenschichtstruktur als aktive Zone, die Quantenschichten und dazwischen liegende Barriereschichten enthält.

Diese Patentanmeldung beansprucht die Priorität der deutschen Patentanmeldung 102005058900.6, deren Offenbarungsgehalt hiermit durch Rückbezug aufgenommen wird.

Mit einem vertikal emittierenden Halbleiterlaser mit externem Resonator, der auch als VECSEL (Vertical External Cavity Surface Emitting Laser) bezeichnet wird, lassen sich hohe Ausgangsleistungen bei gleichzeitig hoher Strahlqualität verwirklichen.

Der Erfindung liegt die Aufgabe zugrunde, einen Halbleiterlaser der eingangs genannten Art mit einer verbesserten Pumpeffizienz zu schaffen.

Diese Aufgabe wird gemäß Patentanspruch 1 durch einen vertikal emittierenden Halbleiterlaser mit einem externen Resonator, einem Halbleiterkörper, der eine Quantenschichtstruktur als aktive Zone aufweist, die Quantenschichten und dazwischen liegende Barriereschichten umfasst, und der auf einer Seite der Quantenschichtstruktur einen Bragg-Reflektor aufweist, wobei eine Pumpstrahlungsquelle vorgesehen ist zur Einstrahlung von Pumpstrahlung in die Quantenschichtstruktur. Der Halbleiterlaser ist dadurch gekennzeichnet, dass der Bragg-Reflektor Schichten umfasst, die aperiodisch derart zueinander angeordnet sind, dass eine Absorption der Pumpstrahlung im wesentlichen innerhalb der Quantenschichtstruktur erfolgt.

Vorteilhafte Weiterbildungen der Erfindung sind Gegenstand der abhängigen Ansprüche.

Als Quantenschicht ist im Rahmen der Erfindung eine Schicht zu verstehen, die so dimensioniert oder strukturiert ist, dass eine für die Strahlungserzeugung wesentliche Quantisierung der Ladungsträger-Energieniveaus z.B. durch Einschluss (confinement) auftritt. Insbesondere beinhaltet die Bezeichnung Quantenschicht keine Angabe über die Dimensionalität der Quantisierung. Sie umfasst somit unter anderem Quantentöpfe, Quantentröge, Quantendrähte, Quantenpunkte und Kombinationen dieser Strukturen.

Eine typische Quantenschichtstruktur weist eine Mehrzahl von Quantenschichten und Barriereschichten auf, wobei die Quantenschichten im allgemeinen wesentlich dünner als die Barriereschichten sind, und jeweils mindestens eine Barriereschicht zwischen zwei benachbarten Quantenschichten angeordnet ist. Eine solche Struktur wird auch als RPG-Struktur (Resonant Periodic Gain) bezeichnet. Im Rahmen der Erfindung sind hierunter sowohl Strukturen mit einem konstanten Abstand benachbarter Quantenschichten als auch Strukturen, bei denen der Abstand benachbarter Quantenschichten variiert, zu verstehen. Weiterhin können auch noch weitere Schichten, beispielweise Zwischenschichten zwischen den Quantenschichten und den Barriereschichten vorgesehen sein, so dass etwa ein treppenartiger Energieverlauf entsteht. Als Barriereschichten sind hierbei jeweils diejenigen Schichten zu verstehen, die die maximale Energie der Quantenschichtstruktur, also die Energiebereiche außerhalb der quantisierenden Strukturen (Quantentröge, Quantendrähte, usw.), festlegen.

Durch die aperiodische Ausführung des Bragg-Reflektors kann in dem Halbleiterkörper eine spektral breite resonante Absorption der Pumpstrahlung mit einhergehender erhöhter Pumpeffizienz erreicht werden. Weiterhin kann die Akzeptanzbreite bezüglich des Einstrahlungswinkels der Pumpstrahlung erhöht werden.

Das Auffinden einer geeigneten Schichtanordnung des aperiodischen Bragg-Reflektors erfolgt beispielsweise durch eine Berechnung des Absorptionsspektrums des Halbleiterkörpers unter Berücksichtung von Mehrfachreflexion an Schichten und Interferenzen. Abhängig von den Parametern des Halbleiterkörpers, insbesondere der Abstände, der Dicken und der Zusammensetzung aller Schichten innerhalb des Halbleiterkörpers, weist das Absorptionsspektrum unter bestimmten Einfallswinkeln bzw. Einfallswinkelbereichen eine oder mehrere spektral breite Absorptionslinien auf.

Weiterhin können zum Auffinden einer geeigneten Schichtanordnung, Spektren berechnet werden, in denen eine Verstärkung durch stimulierte Emission in der aktiven Zone aufgrund des Einstrahlung von Pumpstrahlung berücksichtigt wird (verstärkte Reflexion).

Eine Optimierung der Parameter des Halbleiterkörpers, insbesondere der Schichtabstände und/oder Schichtdicken des aperiodischen Bragg-Reflektors, mit der Zielvorgabe, eine spektral möglichst breite Absorptionslinie bei der gewünschten Pumpstrahlungswellenlänge und eine möglichst große verstärkte Reflexion bei einer gewünschten Wellenlänge für die Vertikalstrahlung zu erhalten, führt dann zu einem Halbleiterlaser mit einer hohen Pumpeffizienz.

In bevorzugten Ausführungsformen ist dabei entweder die Absorption der Pumpstrahlung in den Quantenschichten stärker ist als in den Barriereschichten, oder aber die Absorption der Pumpstrahlung in den Barriereschichten stärker ist als in den Quantenschichten. Besonders bevorzugt tritt dabei innerhalb des Halbleiterkörpers eine stehende Welle der Pumpstrahlung auf, deren Bäuche des elektrischen Feld innerhalb der Quantenschichten bzw. innerhalb der Barriereschichten liegen.

Bezüglich des optischen Pumpens werden zwei komplementäre Pumpmechanismen unterschieden, wobei in beiden Fällen von einer Quantenschichtstruktur ausgegangen wird, die eine Mehrzahl von Quantenschichten mit dazwischen angeordneten Barriereschichten aufweist.

Bei dem ersten Pumpmechanismus ist der vertikal emittierende Halbleiterlaser so ausgelegt, z.B. durch Auswahl einer geeigneten Pumpwellenlänge im Verhältnis zur Wellenlänge im Vertikalstrahlungsfeld, dass die Pumpstrahlung in den zwischen den Quantenschichten angeordneten Barriereschichten absorbiert wird (Barriereschichtpumpen). Die Absorption der Pumpstrahlung führt zur Erzeugung von Elektron-Loch-Paaren, die in der Folge die energetisch tieferliegenden Zustände der Quantenschichten besetzen, so dass eine Besetzungsinversion in den Quantenschichten entsteht. Mittels dieser Besetzungsinversion wird die Vertikalstrahlung generiert.

Bei dem zweiten Pumpmechanismus ist demgegenüber der vertikal emittierende Halbleiterlaser so ausgelegt, dass die Pumpstrahlung direkt in den Quantenschichten absorbiert wird und dort unmittelbar eine Besetzungsinversion erzeugt (Quantenschichtpumpen).

Im Rahmen der Erfindung kann somit sowohl die Methode des Quantenschichtpumpens als auch die des Barriereschichtpumpens eingesetzt werden.

Bevorzugt sind die Quantenschichten der Quantenschichtstruktur periodisch angeordnet. Besonders bevorzugt sind die Quantenschichten (3) mehreren Gruppen angeordnet sind, wobei der Abstand zwischen diesen Gruppen größer ist als der Abstand zwischen zwei benachbarten Quantenschichten innerhalb einer Gruppe. Auf diese Weise können sich in dem Halbleiterkörper ausbildende stehende Wellenfelder der Pumpstrahlung effektiv zum Pumpen genutzt werden.

In einer bevorzugten Ausgestaltung der Erfindung weist der Halbleiterkörper auf einer der Pumpstrahlungsquelle zugewandten Seite der Quantenschichtstruktur eine frontseitige Schichtstruktur auf, die in einer weiteren Ausgestaltung dielektrische und/oder halbleitende Schichten umfasst und deren Schichten in einer weiteren vorteilhaften Ausgestaltung aperiodisch zueinander angeordnet sind. Durch die frontseitige Schichtstruktur wird die Ausbildung stehender Wellenfelder gefördert.

Vorzugsweise ist die frontseitige Schichtstruktur für von der Innenseite des Halbleiterkörpers auftreffende Pumpstrahlung stärker reflektierend, als für von der der Innenseite des Halbleiterkörpers auftreffende, von der Quantenschichtstruktur erzeugte Vertikalstrahlung. Auch auf diese Weise wird die Ausbildung stehender Wellenfelder der Pumpstrahlung gefördert.

Bei einer weiteren vorteilhaften Ausgestaltung der Erfindung weist der Halbleiterkörper auf einer der Pumpstrahlungsquelle abgewandten Seite des Bragg-Reflektors einen rückseitigen Reflektor auf. Auf diese Weise wird ebenfalls die Ausbildung stehender Wellenfelder der Pumpstrahlung gefördert und erreicht, dass Pumpstrahlung zumindest die aktive Zone zumindest zweifach durchläuft. Besonders bevorzugt enthält der rückseitige Reflektor eine metallische Schicht. Metallische Schichten zeichnen sich durch eine hohe Reflektivität mit geringer Wellenlängenabhängigkeit aus und haben zudem eine gute Wärmeleitfähigkeit.

Vorzugsweise ist auf der der Pumpstrahlungsquelle abgewandten Seite des Halbleiterkörpers eine Wärmesenke, vorzugsweise eine metallische Wärmesenke angeordnet. Insbesondere zusammen mit einer metallischen Schicht als rückseitigem Reflektor kann so eine gute Wärmeabgabe des Halbleiterkörpers erreicht werden.

Bevorzugt weist der vertikal emittierender Halbleiterlaser eine epitaktische Halbleiterschichtenfolge auf und besonders bevorzugt eine von einem Aufwachssubstrat abgelöste epitaktische Halbleiterschichtenfolge. In diesem Fall kann die Wärmesenke vorteilhaft ebenfalls als Träger dienen.

Weiterhin ist es möglich, einen oder mehrere externe Pumpstrahlungsspiegel vorgesehen, die aus dem Halbleiterkörper austretende Pumpstrahlung zurück in den Halbleiterkörper reflektieren. Dadurch kann mit Vorteil ein Mehrfachdurchlauf der Pumpstrahlung durch die aktive Zone vorgesehen sein.

In einer weiteren bevorzugten Ausgestaltung der Erfindung ist die Anordnung der Schichten des Bragg-Reflektors derart gewählt, dass die Absorption der Pumpstrahlung für eine vorbestimmte Wellenlänge λₚ oder, besonders bevorzugt, für eine Wellenlänge aus einem Wellenlängenbereich λₚ ± Δλ um die vorbestimmte Wellenlänge λₚ, und einen vorbestimmten Einfallswinkel αₚ der Pumpstrahlung oder, besonders bevorzugt, einen Winkel aus einem Winkelbereich αₚ ± Δα um den vorbestimmten Einfallswinkel αₚ, im wesentlichen innerhalb der Quantenschichten erfolgt. Auf diese Weise wird effektives, mit einem geringen Quantendefekt verbundenes Quantenschichtpumpen ermöglicht. Die Wellenlängen- und Winkeltoleranz führt zu Halbleiterlasern, die einfacher zu justieren und weniger temperatursensitiv sind.

Eine weitere bevorzugte Variante der Erfindung besteht darin, dass die Energiedifferenz zwischen den Photonenenergien der Pumpstrahlung und der von der Quantenschichtstruktur erzeugten Laserstrahlung gleich einem ganzzahligen Vielfachen der Energie eines longitudinalen optischen Phonons der Quantenschichten ist. Dieses hat den Vorteil, dass die Elektronen aus angeregten Pumpniveaus durch eine resonant verstärkte Emission mehrerer Phononen schnell in die oberen Laserniveaus übergehen.

Als Halbleitermaterial wird vorzugsweise eines der Halbleitermaterialien InₓAl_{y}Ga_{1-x-y}As, InₓAl_{y}Ga_{1-x-y}N, InₓAl_{y}Ga_{1-x-y}P, Inₓ₋Ga₁₋ₓAs_{y}N_{1-y} oder ZnₓSe_{y} verwendet, jeweils mit 0≤x≤1, 0≤y≤1, 0≤x+y≤1. Selbstverständlich ist die Erfindung nicht auf eines dieser Halbleitermaterialien beschränkt.

Weitere vorteilhafte Ausgestaltungen der Erfindung ergeben sich aus den im folgenden in Verbindung mit den in den Figuren 1 bis 3 beschriebenen Ausführungsbeispielen.

Es zeigt:
Fig. 1: einen schematisch dargestellten Aufbau eines erfindungsgemäßen vertikal emittierenden Halbleiterlasers mit externem Resonator in einem Ausführungsbeispiel,
Fig. 2: einen schematisch dargestellten Aufbau eines erfindungsgemäßen vertikal emittierenden Halbleiterlasers mit externem Resonator in einem weiteren Ausführungsbeispiel,
Fig. 3: eine Darstellung von Schichtdicken in einer optimierten Ausführungsform des Halbleiterkörpers eines erfindungsgemäßen Lasers, und
Fig. 4: berechnete Spektren der Absorption und der verstärkten Reflexion des in Fig. 3 dargestellten Halbleiterkörpers.

Gleiche oder gleich wirkende Elemente sind in den Figuren mit denselben Bezugszeichen versehen.

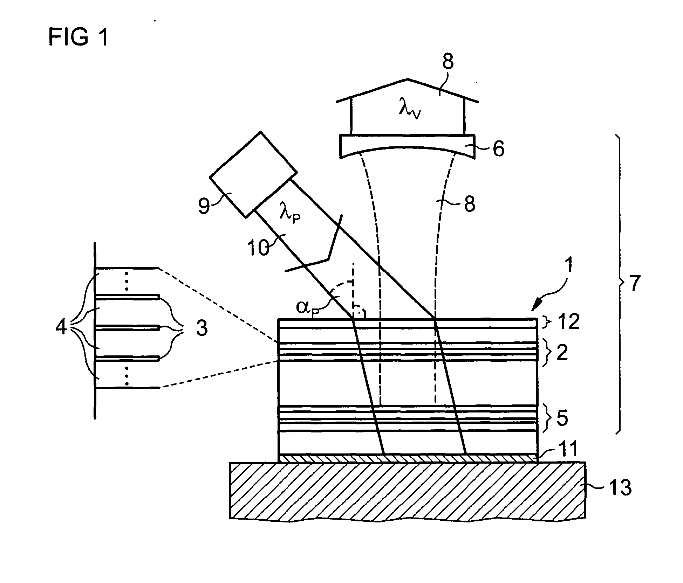

Fig. 1 zeigt schematisch den Aufbau eines vertikal emittierenden Halbleiterlasers mit externem Resonator in einem Ausführungsbeispiel. Der Laser weist einen Halbleiterkörper 1 auf, der eine Quantenschichtstruktur 2 als aktive Zone umfasst, die mehrere Quantenschichten 3 und Barriereschichten 4 aufweist. Bei den Barriereschichten 4 kann es sich auch um eine Kombination mehrerer Schichten verschiedener Halbleitermaterialien handeln. Der Halbleiterkörper 1 weist weiterhin einen aperiodischen Bragg-Reflektor 5 auf. Der Reflektor 5 bildet zusammen mit einem externen Spiegel 6 einen externen Resonator 7 für Vertikalstrahlung 8 einer Wellenlänge λᵥ. Der Halbleiterlaser wird optisch durch eine Pumpstrahlungsquelle 9 gepumpt, die Pumpstrahlung 10 mit einer Wellenlänge λₚ unter einem Einfallswinkel αₚ in den Halbleiterlaser 1 einstrahlt. Auf einer der Pumpstrahlungsquelle 9 abgewandten Seite des Halbleiterkörpers 1 ist ein rückseitiger Reflektor 11 vorgesehen und auf einer der Pumpstrahlungsquelle 9 zugewandten Seite ist eine frontseitige Schichtstruktur 12 vorgesehen, die eine oder mehrere Schichten aufweisen kann. Der Halbleiterkörper 1 ist über den rückseitigen Reflektor 11 mit einer Wärmesenke 13 verbunden.

Vorzugsweise handelt es sich bei der Pumpstrahlungsquelle 9 um einen Halbleiterlaser, insbesondere einen Diodenlaser, wobei die Wellenlänge λₚ der Pumpstrahlung 10 kürzer als die Wellenlänge λᵥ der Vertikalstrahlung 8 ist. Die Pumpstrahlung 10 wird typischerweise schräg auf den Halbleiterkörper 1 eingestrahlt, z.B. unter einem Winkel von 45°.

Ein Teil der in den Halbleiterkörper 11 eindringenden Pumpstrahlung 10 wird von der Quantenschichtstruktur 2 absorbiert. Von dem nicht absorbierten Teil wird ein weiterer Teil am Bragg-Reflektor 5 reflektiert, insbesondere da der Bragg-Reflektor 5 erfindungsgemäß aperiodisch ausgeführt ist und daher eine spektrale Reflektivität hat, die nicht so schmalbandig auf die Vertikalwellenlänge beschränkt ist, wie es bei einem streng periodischen Bragg-Reflektor mit einer gleichen Anzahl an Schichten der Fall sein kann. Der Anteil der Pumpstrahlung 10, der weder absorbiert, noch vom Bragg-Reflektor 5 reflektiert wird, wird von dem rückseitigen Reflektor 11 zurückgespiegelt. Dieser rückseitigen Reflektor 11 kann beispielsweise eine aufgebrachte Metallschicht sein, je nach Wellenlänge λₚ der Pumpstrahlung 10 z.B. aus Gold, Silber oder Kupfer. Über diese Metallschicht kann zudem eine gute thermische Ankopplung an die Wärmesenke 13, die z.B. ein Kühlkörper oder ein Peltierelement sein kann, erreicht.

Zusammen mit der gegenüberliegenden inneren Grenzfläche des Halbleiterkörpers 1 bilden der Bragg-Reflektor 5 und der rückseitigen Reflektor 11 einen Resonator für die Pumpstrahlung 10. Die Eigenschaften dieses Pumpresonators, z.B. seine spektrale Güte, werden unter anderem durch die frontseitige Schichtstruktur 12 modifiziert. Die frontseitige Schichtstruktur 12 kann zu diesem Zweck eine oder mehrere halbleitende und/oder dielektrische Schichten umfassen. Weiterhin kann die frontseitige Schichtstruktur 12 vorteilhaft als Entspiegelung der Grenzfläche des Halbleiterkörpers 1 für die Vertikalstrahlung 8 dienen.

Es sei angemerkt, dass sich der Pumpresonator auch ohne das Vorhandensein der frontseitige Schichtstruktur 12 ausbildet, die frontseitige Schichtstruktur 12 aber vorteilhafterweise eine gezielte Manipulation der Reflexionseigenschaften der Grenzfläche des Halbleiterkörpers 1 ermöglicht. Weiter sei angemerkt, dass bei einem Einfallswinkel von 45° die Pumpstrahlung 10 in dem Halbleiterkörper 1 nicht parallel zur Resonatorachse des Pumpresonators propagiert. Insoweit handelt es sich bei den Resonanzen genau genommen um Quasiresonanzen, deren Wellenlänge gegenüber den Eigenresonanzen des Pumpresonators leicht verschoben ist. Selbstverständlich kann im Rahmen der Erfindung die Pumpstrahlungs 10 auch parallel zu der Resonatorachse eingestrahlt werden.

Durch den Pumpresonator entsteht innerhalb des Halbleiterkörpers 1 eine stehende Welle der Pumpstrahlung 10, in deren Bäuchen des elektrischen Feldes bevorzugt die die Pumpstrahlung 10 absorbierenden Schichten der Quantenschichtstruktur liegen. Je nach dem, ob Quantenschichtpumpens oder Barriereschichtpumpens als Pumpmethode eingesetzt werden, sind das entweder die Quantenschichten 3 oder die Barriereschichten 4.

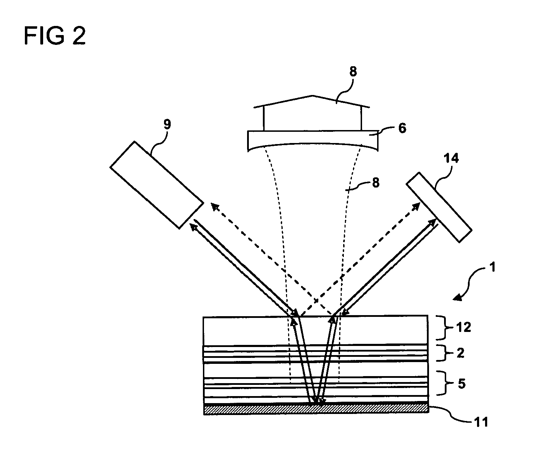

Fig. 2 zeigt ein weiteres Ausführungsbeispiel eines erfindungsgemäßen Halbleiterlaser. Neben bereits im Zusammenhang mit Fig. 1 beschriebenen Elementen ist zur weiteren Erhöhung der Pumpeffizienz ein externer Pumpstrahlungsspiegel 14 vorgesehen, der aus dem Halbleiterkörper 1 austretende Pumpstrahlung 10 zurück in den Halbleiterkörper 1 leitet. Auf diese Weise wird die Pumpstrahlung 10 zweifach durch den Halbleiterkörper 1 geführt. Es ist auch denkbar, mehrerer externe Pumpstrahlungsspiegel 14 vorzusehen, die einen gefalteten, externen Pumpstrahlungsresonator bilden.

Ein erfindungsgemäßer Halbleiterlaser kann beispielsweise hergestellt werden, indem zunächst der Halbleiterkörper 1 in Form einer epitaktischen Halbleiterschichtenfolge auf einem Aufwachssubstrat aufgewachsen wird und nachfolgend auf der von dem Aufwachssubstrat abgewandten Seite die Spiegelschicht aufgebracht wird. Hierauf wird auf der Spiegelschicht ein Träger, der bevorzugt zugleich als Wärmesenke dient, befestigt und dann das Aufwachssubstrat entfernt.

Unabhängig davon, ob bei dem Halbleiterlaser als Pumpmethode Barrierepumpen oder Quantenschichtpumpen eingesetzt wird, ist für einen effizienten Betrieb des Halbleiterlasers ist in beiden Fällen zur Erzielung einer hohen Pumpeffizienz eine ausreichend hohe Absorption der Pumpstrahlung erforderlich.

Das Barriereschichtpumpen weist diesbezüglich einen Vorteil gegenüber dem Quantenschichtpumpen auf, da die Barriereschichten in der Regel erheblich dicker ausgeführt sind als die Quantenschichten und daher eine hohe Absorption der Pumpstrahlung leichter erreichbar ist.

Ein prinzipiell auftretender Verlustmechanismus bei beiden Pumpmechanismen ist die Relaxation von Ladungsträgern aus energetisch höherliegenden angeregten Zuständen in die energetisch tieferliegenden, strahlenden Niveaus der Quantenschichten dar. Dieser als Quantendefekt bezeichnete Energieverlust äußert sich in der Erzeugung von Wärme, die an das Kristallgitter abgegeben wird und somit den Halbleiterlaser unerwünscht aufheizt. Der Energieverlust ist proportional zur Energiedifferenz zwischen der kurzwelligeren und damit höherenergetischeren Pumpstrahlung zur langwelligeren und damit niederenergetischeren Vertikalstrahlung. Die maximale Ausgangsleistung ist somit durch die maximal zulässige thermische Belastung begrenzt.

Da zur Erzeugung von Elektron-Loch-Paaren beim Barriereschichtpumpen eine höhere Energie erfordert, ist jedoch im Hinblick auf den Quantendefekt das Quantenschichtpumpen vorteilhafter. Weiterhin werden nicht alle durch die Pumpstrahlung in den Barriereschichten freigesetzten Ladungsträger in die Quantenschichten eingefangen, d.h. die Eingangseffizienz ist zudem kleiner als 1.

Es ist somit erstrebenswert, eine Ausführungsform des erfindungsgemäßen Halbleiterlasers so zu optimieren, dass Quantenschichtpumpen mit einer hohen Absorption der Pumpstrahlung 10 vorliegt.

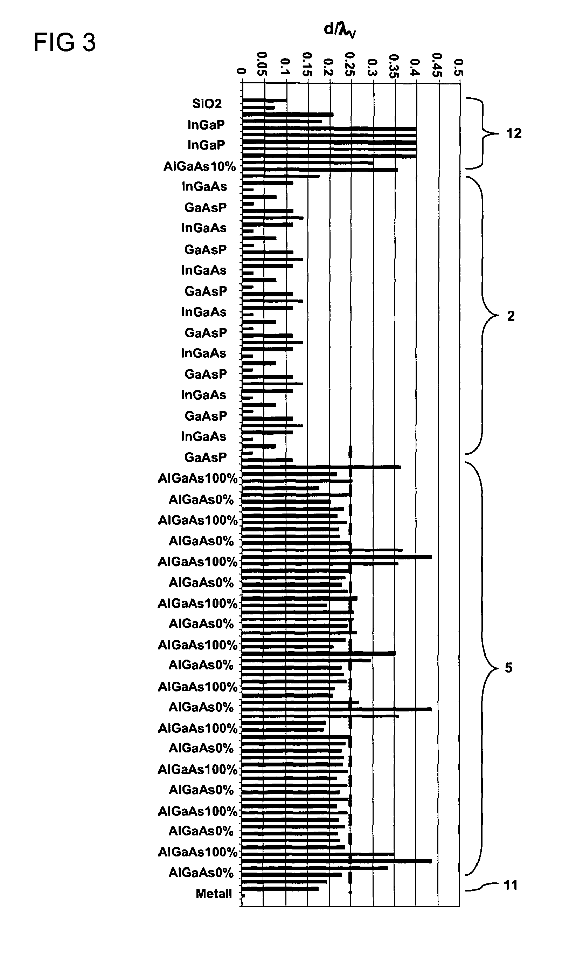

Fig. 3 zeigt schematisch eine optimierte Ausführungsform des Halbleiterkörpers 1 für einen der Fig. 1 entsprechenden erfindungsgemäßen Halbleiterlaser. Im Folgenden benutzte Bezugszeichen entsprechen denen in Fig. 1.

Der Laser ist für Vertikalstrahlung 8 einer Wellenlänge λᵥ =1050 nm ausgelegt und für Pumpstrahlung 10 einer Wellenlänge λₚ =940 nm, auf den Halbleiterkörper 1 gestrahlt in einem Einfallswinkel αₚ =45°. Die Überschussenergie, d.h. der Quantendefekt, der Pumpstrahlung beträgt etwa 11%. Dieser Wert zeigt, dass der Pumpmechanismus des optischen Pumpens Quantenschichtpumpen ist, da beim Barriereschichtpumpen deutlich größere Überschussenergien von etwa 20% notwendig sind. Dargestellt sind optimierte Schichtdicken in Einheiten der Wellenlänge λᵥ im jeweiligen Material (optische Dicke).

Der Halbleiterkörper weist (von oben nach unten in Fig. 3) einen rückseitiger Reflektor 11 eines Metalls einer Dicke von etwa 1 nm auf, auf den ein Bragg-Reflektor 5 bestehend aus einer Folge von alternierend je 30 AlAs und 30 AlGaAs Schichen folgt. Darauf folgt eine aus 7 Perioden bestehende Quantenschichtstruktur 2. Eine Periode der Quantenschichtstruktur 2 setzt sich dabei aus den folgenden Schichten in den angegebenen Schichtdicken zusammen: GaAsP, 30 nm; InGaAs, 10 nm; GaAsP, 30 nm; InGaAs 10 nm; GaAsP 30 nm und AlGaAs 40 nm. Dabei sind die InGaAs-Schichten die Quantenschichten 3 und die AlGaAs- und GaAsP-Schichten die Barriereschichten 4. Die GaAsP-Schichten dienen dabei der Spannungskompensation. Auf der Quantenschichtstruktur 2 ist abschließend eine frontseitige Schichtstruktur 12 vorgesehen, die mehrere InGaP-Schichten und SiN/SiO₂-Schichten umfasst.

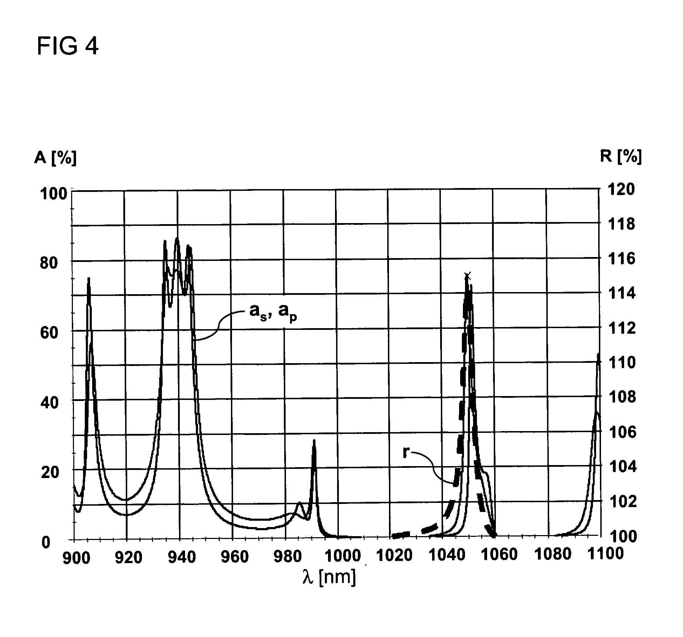

Die in Fig. 3 angegeben optischen Schichtdicken sind das Ergebnis einer iterativen Optimierung, basierend auf berechneten Absorptionsspektren und Spektren verstärkter Reflexion, von denen im Folgenden Beispiele im Zusammenhang mit Fig. 4 näher erläutert werden. Deutlich zu erkennen ist, dass die Schichtdicken des Bragg-Reflektors 5 von den Schichtdicken λᵥ /4 eines periodischen Bragg-Reflektors, angedeutet durch die horizontale gestrichelte Linie, abweichen. Die Abweichungen sind individuell für jede der Schichten, es ist keine übergeordnete Periodizität erkennbar. Die Zielkriterien für die Optimierung waren eine hohe Absorption der Pumpstrahlung 11 in einem breiten Wellenlängenbereich (große Wellenlängenakzeptanzbreite) bei gleichzeitig hoher verstärkter Reflexion für die Vertikalstrahlung 8.

Die Berechnung der Spektren erfolgt mithilfe der so genannten Transfermatrixmethode unter Berücksichtigung von Mehrfachreflexion und Absorption an den Einzelschichten. Die Schichtenabfolge, sowie Unter- und Obergrenzen der einzelnen Schichtdicken werden dabei vorgegeben. Ausgehend von vorgegebenen Startwerten für die Schichtdicken werden dann iterativ Spektren berechnet und alle oder eine ausgewählte Gruppe von Schichtdicken so variiert, dass die Zielkriterien möglichst gut erfüllt sind. Im gezeigten Beispiel wurden die Schichtdicken des Bragg-Reflektors 5 und der frontseitige Schichtstruktur 12 zur Optimierung variiert.

Fig. 4 zeigt berechnete Absorptionsspektren aₚ, aₛ und ein berechnetes Spektrum der verstärkten Reflexion r für den in Fig. 3 dargestellten Schichtaufbau des Halbleiterkörpers 1. Die Absorptionsspektren aₚ, aₛ sind passend zur Pumpstrahlung 10 für einen Einfallswinkel von 45° berechnet und das Spektrum der verstärkten Reflexion r ist passend zur Vertikalstrahlung 8 für einen Einfallswinkel von 0° berechnet.

Die beiden Absorptionsspektren aₚ, aₛ, dargestellt als dünne durchgezogene Kurven, geben die Absorption A (linke Ordinatenachse) bei Durchgang durch den Halbleiterkörper 1 für Strahlung, die parallel zur Einfallsebene polarisiert ist (p-Polarisation) und für Strahlung, die senkrecht zur Einfallsebene polarisiert ist (s-Polarisation) wieder.

Das Spektrum r, dargestellt als dickere gestrichelte Kurve, gibt die verstärkte Reflexion R (rechte Ordinatenachse) durch den Halbleiterkörper 1 wieder. Bei der Berechnung der Reflexion R ist eine Verstärkung der Strahlung aufgrund stimulierter Emission innerhalb der Quantenschichten 3 mitberücksichtigt, was in einer Reflexion größer 100% resultiert. Die Berechnung gibt somit im Prinzip den Halbleiterlaser in einem gepumpten Zustand, d.h. wie beim Einstrahlen der Pumpstrahlung 10 wie im Betrieb, wieder. Eingang in die Berechnung findet der gepumpte Zustand durch die Berücksichtigung einer Ladungsträgerdichte in den Quantenschichten 3. Diese Ladungsträgerdichte ist in parametrisierter Form temperaturabhängig und in Abhängigkeit der Pumplichtabsorption vorgegeben.

Es ist in den Absorptionsspektren aₚ, aₛ deutlich eine breites Absorptionsstruktur für p- und s-polarisierte Strahlung im Wellenlängenbereich um 940 nm erkennbar. Auf einer Breite von etwa 15 nm ist die Absorption durchweg größer als etwa 70 % und beträgt im Mittel etwa 75 %. Absorptionslinien von vergleichbaren Halbleiterkörpern mit periodischem Bragg-Reflektor weisen demgegenüber Linienbreiten von etwa 1-2 nm auf. Der erfindungsgemäße Halbleiterlaser bietet somit eine große Wellenlängenakzeptanzbreite für die Pumpstrahlung, was z.B. zu einer geringeren Temperatursensitivität führt.

Wie das Spektrum der verstärkten Reflexion r zeigt, wird bei einer Wellenlänge von 1050 nm, also bei der Wellenlänge λᵥ der Vertikalstrahlung, eine verstärkte Reflexion R von über 115 % erreicht. Dieser Wert zeigt, dass die absorbierte Energie der Pumpstrahlung 10 maßgeblich in einem effektiven Pumpprozess umgesetzt wird, statt in Verlustprozesse (z.B. Gitterschwingungen, Erwärmung) zu fließen.

Zusammenfassend wird bei dem erfindungsgemäßen Halbleiterlaser somit mit etwa 75 % eine hohe Absorption der Pumpstrahlung mit großer Wellenlängenakzeptanzbreite von 15 nm und eine verstärkte Reflexion von über 115 % für die Vertikalstrahlung für den Fall des Quantenschichtpumpens mit einem geringen Quantendefekt von etwa 11 % erreicht. Mit der großen Wellenlängenakzeptanzbreite geht weiterhin vorteilhaft eine große Winkelakzeptanzbreite beim Einstrahlungswinkel der Pumpstrahlung 10 einher.

Es versteht sich, dass eine entsprechende Optimierung auch für Pumpstrahlung, deren Wellenlänge bevorzugt zur Absorption in den Barriereschichten 4 (Barriereschichtpumpen) führt, möglich ist. Die Optimierung kann weiterhin so erfolgen, dass eine Gewichtung der Zielkriterien vorgegeben wird, oder dass weitere Zielkriterien berücksichtigt werden.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Vertikal emittierender Halbleiterlaser mit
- einem externen Resonator (7),
- einem Halbleiterkörper (1), der eine Quantenschichtstruktur (2) als aktive Zone aufweist, die Quantenschichten (3) und dazwischen liegende Barriereschichten (4) umfasst, und der auf einer Seite der Quantenschichtstruktur (2) einen Bragg-Reflektor (5) aufweist, wobei
- eine Pumpstrahlungsquelle (9) vorgesehen ist zur Einstrahlung von Pumpstrahlung (10) in die Quantenschichtstruktur (2),
**dadurch gekennzeichnet, dass**
der Bragg-Reflektor (5) Schichten umfasst, die aperiodisch derart zueinander angeordnet sind, dass eine Absorption der Pumpstrahlung (10) im wesentlichen innerhalb der Quantenschichtstruktur (2) erfolgt.

2. Vertikal emittierender Halbleiterlaser nach Anspruch 1, bei dem die Absorption der Pumpstrahlung (10) in den Quantenschichten (3) stärker ist als in den Barriereschichten (4).

3. Vertikal emittierender Halbleiterlaser nach Anspruch 2, bei dem innerhalb des Halbleiterkörpers (1) eine stehende Welle der Pumpstrahlung (10) auftritt, deren Bäuche des elektrischen Feld innerhalb der Quantenschichten (3) liegen.

4. Vertikal emittierender Halbleiterlaser nach Anspruch 1, bei dem die Absorption der Pumpstrahlung (10) in den Barriereschichten (4) stärker ist als in den Quantenschichten (3).

5. Vertikal emittierender Halbleiterlaser nach Anspruch 4, bei dem innerhalb des Halbleiterkörpers (1) eine stehende Welle der Pumpstrahlung (10) auftritt, deren Bäuche des elektrischen Feld innerhalb der Barriereschichten (4) liegen.

6. Vertikal emittierender Halbleiterlaser nach einem der Ansprüche 1 bis 5, bei dem die Quantenschichten (3) der Quantenschichtstruktur (2) periodisch angeordnet sind.

7. Vertikal emittierender Halbleiterlaser nach einem der Ansprüche 1 bis 6, bei dem die Quantenschichten (3) in mehreren Gruppen angeordnet sind, wobei der Abstand zwischen diesen Gruppen größer ist als der Abstand zwischen zwei benachbarten Quantenschichten innerhalb einer Gruppe.

8. Vertikal emittierender Halbleiterlaser nach einem der Ansprüche 1 bis 7, bei dem der Halbleiterkörper (1) auf einer der Pumpstrahlungsquelle (9) zugewandten Seite der Quantenschichtstruktur (2) eine frontseitige Schichtstruktur (12) aufweist.

9. Vertikal emittierender Halbleiterlaser nach Anspruch 8, bei dem die frontseitige Schichtstruktur (12) dielektrische und/oder halbleitende Schichten umfasst.

10. Vertikal emittierender Halbleiterlaser nach einem der Ansprüche 8 oder 9, bei dem die Schichten der frontseitige Schichtstruktur (12) aperiodisch zueinander angeordnet sind.

11. Vertikal emittierender Halbleiterlaser nach einem der Ansprüche 8 bis 10, bei dem die frontseitige Schichtstruktur (12) für von der Innenseite des Halbleiterkörpers (1) auftreffende Pumpstrahlung (10) stärker reflektierend ist als für von der der Innenseite des Halbleiterkörpers (1) auftreffende, von der Quantenschichtstruktur (2) erzeugte Vertikalstrahlung (8).

12. Vertikal emittierender Halbleiterlaser nach einem der Ansprüche 1 bis 11, bei der der Halbleiterkörper (1) auf der auf einer der Pumpstrahlungsquelle (9) abgewandten Seite des Bragg-Reflektors (5) einen rückseitigen Reflektor (11) aufweist.

13. Vertikal emittierender Halbleiterlaser nach Anspruch 12, bei dem der rückseitige Reflektor (11) eine oder mehrere metallische und/oder dielektrische Schichten und/oder einen weiteren Bragg-Reflektor enthält.

14. Vertikal emittierender Halbleiterlaser nach einem der Ansprüche 1 bis 13, bei dem zur Bildung des externen Resonators (7) ein externer Spiegel (6) vorgesehen ist.

15. Vertikal emittierender Halbleiterlaser nach einem der Ansprüche 1 bis 12, bei dem mindestens ein externer Pumpstrahlungsspiegel (14) vorgesehen ist, der aus dem Halbleiterkörper (1) austretende Pumpstrahlung (10) zurück in den Halbleiterkörper (1) reflektiert.

16. Vertikal emittierender Halbleiterlaser nach einem der Ansprüche 1 bis 15, bei dem die Schichtdicken des Bragg-Reflektors (5) derart gewählt sind, dass die Absorption der Pumpstrahlung (10) für eine vorbestimmte Wellenlänge λₚ und einen vorbestimmten Einfallswinkel αₚ der Pumpstrahlung (10) im wesentlichen innerhalb der Quantenschichten (3) erfolgt.

17. Vertikal emittierender Halbleiterlaser nach Anspruch 16, bei dem die Anordnung der Schichten des Bragg-Reflektors (5) derart gewählt ist, dass die Absorption der Pumpstrahlung (10) für Pumpstrahlung (10) einer Wellenlänge aus einem Wellenlängenbereich λₚ ± Δλ um die vorbestimmte Wellenlänge λₚ bei dem vorbestimmten Einfallswinkel αₚ der Pumpstrahlung (10) im wesentlichen innerhalb der Quantenschichten (3) erfolgt.

18. Vertikal emittierender Halbleiterlaser nach einem der Ansprüche 16 oder 17, bei dem die Anordnung der Schichten des Bragg-Reflektors derart gewählt ist, dass die Absorption der Pumpstrahlung (10) für Pumpstrahlung (10) der vorbestimmte Wellenlänge λₚ innerhalb eines Winkelbereichs αₚ ± Δα um den vorbestimmten Einfallswinkel αₚ der Pumpstrahlung (10) im wesentlichen innerhalb der Quantenschichten (3) erfolgt.

19. Vertikal emittierender Halbleiterlaser nach einem der Ansprüche 16 bis 18, bei dem die Anordnung der Schichten des Bragg-Reflektors derart gewählt ist, dass die Absorption der Pumpstrahlung (10) für Pumpstrahlung (10) der Wellenlänge aus dem Wellenlängenbereich λₚ ± Δλ um die vorbestimmte Wellenlänge λₚ innerhalb des Winkelbereichs αₚ ± Δα um den vorbestimmten Einfallswinkel αₚ der Pumpstrahlung (10) im wesentlichen innerhalb der Quantenschichten (3) erfolgt.

20. Vertikal emittierender Halbleiterlaser nach einem der Ansprüche 16 bis 19, bei dem der vorbestimmte Einstrahlungswinkel αₚ der Pumpstrahlung (10) zwischen 0° und 80°, und insbesondere zwischen 0° und 60° liegt.

21. Vertikal emittierender Halbleiterlaser nach einem der Ansprüche 17 oder 19, bei dem der Wellenlängenbereich λₚ ± Δλ eine halbe Breite Δλ von mindestens 5 nm aufweist.

22. Vertikal emittierender Halbleiterlaser nach einem der Ansprüche 18 oder 19, bei dem der Winkelbereich αₚ ± Δα eine halbe Breite Δα von mindestens 5°aufweist.

23. Vertikal emittierender Halbleiterlaser nach einem der Ansprüche 1 bis 22, bei dem die Energiedifferenz zwischen den Photonenenergien der Pumpstrahlung (10) und der von der Quantenschichtstruktur (2) erzeugten Vertikalstrahlung (8) gleich einem ganzzahligen Vielfachen der Energie eines longitudinalen optischen Phonons der Quantenschichten (3) ist.

24. Vertikal emittierender Halbleiterlaser nach einem der Ansprüche 1 bis 23, der, insbesondere innerhalb der Quantenschichtstruktur (2), mindestens eines der Halbleitermaterialien InₓAl_{y}Ga_{1-x-y}As, InₓAl_{y}Ga_{1-x-y}N, InₓAl_{y}Ga_{1-x-y}P, InₓGa₁₋ₓAs_{y}N_{1-y} oder ZnₓSe_{y} jeweils mit 0≤x≤1, 0≤y≤1, 0≤x+y≤1 enthält.

25. Vertikal emittierender Halbleiterlaser nach einem der Ansprüche 1 bis 24, der eine epitaktische Halbleiterschichtenfolge aufweist.

26. Vertikal emittierender Halbleiterlaser nach Anspruch 25, der eine von einem Aufwachssubstrat abgelöste epitaktische Halbleiterschichtenfolge aufweist.

27. Vertikal emittierender Halbleiterlaser nach einem der Ansprüche 1 bis 26, bei der auf der der Pumpstrahlungsquelle (9) abgewandten Seite des Halbleiterkörpers (1) eine Wärmesenke (13), vorzugsweise eine metallische Wärmesenke angeordnet ist.

28. Vertikal emittierender Halbleiterlaser nach einem der Ansprüche 1 bis 27, bei der die Quantenschichten (3) als Quantentröge, Quantendrähte, Quantenpunkte oder als Kombination dieser Strukturen ausgebildet sind.
